# FASCICULE DE BREVET EUROPEEN

(11) **EP 3 320 128 B1**
(45) Date de publication et mention de la délivrance du brevet: **11.09.2019**
(21) Numéro de dépôt: 16744809.1
(22) Date de dépôt: 08.07.2016
(51) Int. Cl.: C23C 28/04, C23C 30/00, C23C 14/30, C23C 4/129, C23C 4/134, C23C 14/08

(54) **PIECE REVÊTUE D'UN REVÊTEMENT DE PROTECTION CONTRE LES CMAS**
MIT EINER BESCHICHTUNG ZUM SCHUTZ GEGEN CMS BESCHICHTETES TEIL
PART COATED WITH A COATING FOR PROTECTION AGAINST CMAS

(30) Priorité: 08.07.2015 FR 1556457
(43) Date de publication de la demande: 16.05.2018
(73) Titulaire: Safran Aircraft Engines, 75015 Paris (FR)
(72) Inventeur: BILHE, Pascal, Fabrice, 77550 Moissy-Cramayel Cedex (FR); MALIE, André, Hubert, Louis, 77550 Moissy-Cramayel Cedex (FR)
(74) Mandataire: Cabinet Beau de Loménie
(86) Numéro de dépôt international: PCT/FR2016/051750
(87) Numéro de publication internationale: WO 2017/006069

(56) Documents cités:
- EP-A1- 2 236 650
- EP-A1- 2 631 321
- EP-A2- 2 778 147
- US-A1- 2006 280 963

## Description

### Arrière-plan de l'invention

La présente invention se rapporte au domaine général des revêtements formant une barrière thermique utilisés pour isoler thermiquement des pièces métalliques dans des environnements à haute température. L'invention s'applique plus particulièrement, mais non exclusivement, aux barrières thermiques utilisées pour protéger les pièces en superalliages des turbines à gaz aéronautiques.

Les pièces présentes dans des parties chaudes des turbomachines aéronautiques opérant en milieu désertique, ou très pollué, se dégradent très rapidement à cause de l'attaque du sable et des composés alcalins présents dans l'air ingéré par le moteur. Ces composés, connus sous le nom de « CMAS » (regroupant notamment des oxydes de calcium, de magnésium, d'aluminium et de silicium), peuvent dégrader le revêtement jouant le rôle de barrière thermique recouvrant certaines pièces des parties chaudes de la turbomachine.

Parmi les mécanismes de dégradation de la barrière thermique par les composés CMAS, on distingue notamment l'infiltration à l'état liquide des composés CMAS dans la barrière thermique, et la dissolution-reprécipitation de la barrière thermique (constituée traditionnellement d'une céramique à base de zircone stabilisée à l'Yttrine YSZ), en nodules isolés de zircone appauvris en Yttrine. Ces deux mécanismes abaissent les propriétés mécaniques de la barrière thermique qui peut conduire à sa fissuration au cours des phases de refroidissement du moteur. De plus, l'ingestion de particules solides créée des phénomènes d'érosion de la barrière thermique qui s'écaille et laisse alors le substrat métallique sous-jacent à nu, réduisant ainsi la durée de vie des pièces.

Des solutions existent pour limiter l'infiltration des CMAS dans la barrière thermique. On citera par exemple l'utilisation d'un revêtement protecteur de la barrière thermique à base de zircone dopée au gadolinium (sous la désignation de zirconate de gadolinium par exemple), ou encore l'utilisation d'alumine ou d'oxyde de titane. Ces revêtements, en réagissant avec les CMAS, favorisent leur précipitation, et permettent ainsi de limiter leur pénétration dans la barrière thermique. Cependant, ces revêtements présentent l'inconvénient d'être sacrificiels, ce qui nécessite un entretien permanent, ainsi qu'une surveillance régulière de l'état des pièces. De plus, la disponibilité des éléments chimiques (terres rares notamment) présents dans ces revêtements est de plus en plus limitée, ce qui constitue une contrainte supplémentaire à leur utilisation.

Il existe donc un besoin pour disposer d'une pièce revêtue d'un revêtement de protection formant une barrière thermique qui présente une durée de vie élevée dans les environnements et les conditions de fonctionnement d'une turbomachine aéronautique.

### Objet et résumé de l'invention

La présente invention a donc pour but principal de pallier de tels inconvénients en proposant une pièce revêtue comprenant un substrat métallique et/ou intermétallique et un revêtement de protection formant une barrière thermique recouvrant ledit substrat, le revêtement de protection comprenant une première couche céramique, caractérisé en ce que le revêtement de protection comprend en outre une deuxième couche présente sur la première couche, la deuxième couche comprenant majoritairement en masse un premier minerai de feldspath ayant une température de fusion supérieure ou égale à 1010°C et présentant une épaisseur supérieure ou égale à 10 µm, la deuxième couche présentant un taux de cristallinité supérieur ou égal à 5%.

Par « recouvert » on entend que le substrat de la pièce est recouvert sur tout ou partie de sa surface accessible ou à protéger thermiquement.

Le revêtement de la pièce revêtue selon l'invention est tout d'abord remarquable en ce qu'il comprend une couche externe imperméable aux CMAS, ou en d'autres termes étanche aux CMAS. En effet, la deuxième couche garde une forme solide à haute température, et empêche la pénétration des CMAS liquides dans la première couche céramique sous-jacente (qui constitue la couche isolante thermiquement du revêtement). Par « haute température », on entend des températures de l'ordre de 1000°C, comme cela peut être le cas dans une turbomachine aéronautique en fonctionnement.

Aussi, une telle couche n'est plus sacrificielle comme pour les revêtements de l'art antérieur, notamment parce qu'elle conserve une forme solide à haute température. On entend par l'expression « plus sacrificielle » que la couche ainsi déposée présente dès son élaboration la capacité d'être chimiquement compatible (parce que de composition chimique proche) avec les CMAS. La durée de vie d'une telle couche est donc augmentée par rapport aux revêtements de l'art antérieur.

En outre, le minerai de la deuxième couche est stable chimiquement avec la silice et l'alumine, qui sont des composés présents dans les CMAS et les autres sables ou céments qui peuvent être ingérés par la turbomachine. En effet, les feldspaths (ou les minerais de la famille des feldspaths) sont des aluminosilicates qui présentent une phase majoritaire de silice. De plus, ces minerais sont compatibles avec la présence d'eau avec laquelle ils se dégradent selon une réaction de décomposition très lente.

La composition de la première couche en céramique n'est pas modifiée par l'ajout de la deuxième couche qui est indépendante de la première (elles peuvent notamment être déposées indépendamment l'une sur l'autre). Ainsi, les performances de la première couche céramique ne sont pas altérées par la présence de la deuxième couche protectrice, ni par son procédé de dépôt.

L'épaisseur supérieure ou égale à 10 µm de la deuxième couche permet d'améliorer d'une part la résistance aux CMAS, mais également la résistance du revêtement à l'érosion et aux impacts. La pièce revêtue selon l'invention dispose ainsi d'une deuxième couche de revêtement d'épaisseur contrôlée et suffisante pour obtenir les avantages précités. Ce n'est par exemple pas le cas pour des revêtements comprenant une couche de protection qui est formée au sein d'une turbomachine en fonctionnement, à l'issue par exemple d'une réaction chimique impliquant une couche de barrière thermique et des CMAS. En effet, une couche de protection formée *in situ* dans la turbomachine, et non avant la première utilisation dans la turbomachine, peut présenter une épaisseur plus faible, non contrôlée et inhomogène sur la pièce car elle dépend notamment de la diffusion des CMAS dans la barrière thermique et des conditions environnementales (température, composition des CMAS) variables dans la turbomachine.

Enfin, la deuxième couche du revêtement selon l'invention permet également de boucher les macroporosités qui peuvent être présentes en surface de la première couche céramique. Par exemple, lorsque la première couche céramique comprend de la zircone stabilisée à l'Yttrine, elle présente une structure lamellaire ou en bâtonnets (colonnaire) avec une rugosité de surface non nulle, et il devient alors avantageux de disposer d'une couche de protection pouvant la recouvrir et boucher ses porosités en surface.

Dans un exemple de réalisation, la deuxième couche du revêtement présente une épaisseur supérieure ou égale à 20 µm, par exemple supérieure ou égale à 50 µm.

Dans un exemple de réalisation, la deuxième couche du revêtement présente une épaisseur supérieure ou égale au tiers de l'épaisseur de la première couche.

La deuxième couche présente un taux de cristallinité supérieur ou égal à 5%, par exemple supérieur ou égal à 10%. Ce taux de cristallinité peut être mesuré, de façon connue en soi, à l'aide de techniques telles que la diffraction des rayons X ou la spectroscopie Raman. La cristallinité de la deuxième couche permet notamment d'améliorer l'adhérence entre la première couche et la deuxième couche du revêtement.

De préférence, la première couche céramique comprend de la zircone.

De préférence également, la première couche céramique comprend de la zircone stabilisée à l'Yttrine. En variante, la première couche céramique peut également comprendre de la zircone dopée aux terres rares ou avec une composition à base d'oxydes ternaires. Dans la famille de systèmes ternaires, on peut par exemple citer les systèmes à base de zircone yttriée dopés par un troisième oxyde distinct tel qu'un oxyde de l'un des éléments chimiques suivants : ytterbium (Yb), néodyme (Nd), dysprosium (Dy), gadolinium (Gd), niobium (Nb), tantale (Ta), samarium (Sm).

Dans un mode de réalisation, la deuxième couche comprend majoritairement en masse de l'anorthite. Par « anorthite » on entend les minerais de feldspath de composition générale CaAl₂Si₂O₈, dont les minerais polymorphes de l'anorthite font également partie.

L'anorthite présente l'avantage d'avoir une température de fusion élevée (plus de 1500°C), sa fusion étant congruente (c'est-à-dire que le changement de phase solide/liquide se produit sans modification de sa composition chimique, ni dissociation en des composés secondaires). L'anorthite est également très stable et se décompose très peu dans les conditions de pression et de température imposées par exemple dans une turbomachine aéronautique. En outre, l'anorthite présente une densité faible (ce qui permet de réduire les efforts mécaniques centrifuges sur les pièces en rotation, par rapport à des revêtements plus denses), un coefficient de dilatation thermique proche de celui du superalliage, et une conductivité thermique comparable à celle de la céramique isolante de la première couche du revêtement (la conductivité thermique de l'anorthite est de l'ordre de 2W.m⁻¹.K⁻¹). Enfin, l'utilisation de l'anorthite est aisée, car plusieurs procédés de synthèse et de dépôt de l'anorthite sont connus (par exemple : sol-gel, barbotine, dépôt chimique phase vapeur, pulvérisation, projection thermique, etc.).

Dans certains exemples de réalisation, le revêtement comprend en outre une troisième couche comprenant majoritairement en masse un deuxième minerai de feldspath ayant une température de fusion supérieure ou égale à 1010°C, la troisième couche étant située sous la première couche. Ce dépôt ajoute une protection supplémentaire au substrat si la première couche céramique vient à se dégrader et laisse traverser des CMAS fondus vers les couches sous-jacentes. Un tel dépôt est possible car le matériau formant la deuxième couche comprend une phase alumine, il est alors compatible avec la sous-couche de liaison (disposée généralement entre le substrat et la première couche en céramique) qui est souvent riche en aluminium pour avoir un caractère aluminoformeur.

Dans certains modes de réalisation, le revêtement de protection comprend en outre une quatrième couche recouvrant la deuxième couche comprenant de l'alumine et/ou de l'oxyde de titane. L'alumine et l'oxyde de titane (TiO₂) sont des agents nucléants qui permettent de faire précipiter les CMAS fondus avant qu'ils n'attaquent les couches sous-jacentes du revêtement.

Aussi, la deuxième couche peut comprendre en outre de l'alumine et/ou de l'oxyde de titane, pour les mêmes raisons que précédemment. Un dépôt d'alumine et/ou d'oxyde de titane peut être fait en même temps que le dépôt du feldspath, dans ce cas la deuxième couche comprend des phases dispersées d'alumine et/ou d'oxyde de titane dans une phase feldspath majoritaire.

Une pièce revêtue selon l'invention peut être une pièce de turbomachine aéronautique, par exemple : une aube de turbine, un distributeur de turbine, une aube mobile, un anneau de turbine, une chambre de combustion, une tuyère d'éjection de kérosène, etc.

L'invention vise aussi un procédé de fabrication d'une pièce revêtue comprenant un substrat métallique et/ou intermétallique et un revêtement de protection formant une barrière thermique recouvrant ledit substrat, le procédé comprenant la formation d'une première couche céramique sur le substrat métallique et/ou intermétallique, caractérisé en ce qu'il comprend en outre la formation sur la première couche céramique d'une deuxième couche, la deuxième couche comprenant majoritairement en masse un minerai de feldspath ayant une température de fusion supérieure ou égale à 1010°C et présentant une épaisseur supérieure ou égale à 10 µm, la deuxième couche présentant un taux de cristallinité supérieur ou égal à 5%.

Le procédé de fabrication de la pièce revêtue selon l'invention peut être effectué préalablement à une première utilisation de la pièce dans une turbomachine. En d'autres termes, le revêtement de la pièce revêtue selon l'invention peut être formé préalablement à la première utilisation de la pièce dans une turbomachine. De la sorte, le revêtement de protection de la pièce selon l'invention peut être homogène en composition et en épaisseur sur l'ensemble de la pièce, indépendamment des conditions d'utilisation ultérieures de la pièce.

Enfin, l'invention vise un procédé d'utilisation d'une pièce revêtue telle que celle définie précédemment, comprenant l'utilisation de la pièce dans un environnement oxydant à une température supérieure à 1000°C et en présence d'aluminosilicates de calcium et de magnésium (CMAS). Ces conditions peuvent correspondre aux conditions rencontrées dans une turbomachine en fonctionnement.

### Brève description des dessins

D'autres caractéristiques et avantages de la présente invention ressortiront de la description faite ci-dessous, en référence aux dessins annexés qui en illustrent des exemples de réalisation dépourvu de tout caractère limitatif. Sur les figures :

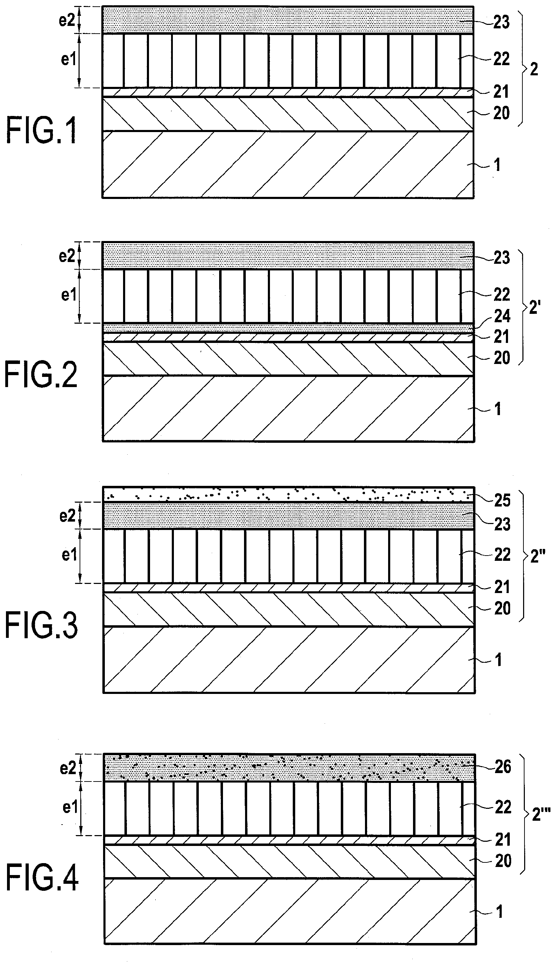

- les figures 1 à 4 illustrent différentes pièces comprenant des substrats recouverts d'un revêtement de protection formant une barrière thermique selon différents modes de réalisation de l'invention.

### Description détaillée de l'invention

La **figure 1** montre une vue en coupe d'un revêtement 2 de protection formant une barrière thermique sur un substrat métallique (et/ou intermétallique) 1 d'une pièce revêtue selon l'invention. La pièce peut par exemple être une aube de turbine de turbomachine aéronautique. Le substrat 1 peut comprendre typiquement un superalliage à base de fer, de cobalt ou de nickel. On notera que le substrat 1 peut également comprendre un matériau intermétallique du type aluminiures de titane, ou encore des siliciures de niobium, des siliciures de molybdène, etc. Le revêtement 2 recouvre le substrat 1, et est directement au contact de celui-ci.

De façon connue en soi, le revêtement 2 comprend tout d'abord une couche dite de liaison 20 qui assure notamment la protection contre la corrosion et l'oxydation du substrat 1. Cette couche de liaison 20, connue en soi, s'oxyde partiellement à sa surface sur une certaine épaisseur lorsqu'elle est portée à haute température pour former une couche d'oxyde 21 (aussi appelée TGO pour « Thermally Grown Oxide »). La couche de liaison 20 peut par exemple comprendre un aluminiure simple ou modifié.

Une première couche 22 en céramique recouvre ensuite la couche d'oxyde 21. La première couche 22 est ici directement au contact de la couche d'oxyde 21 qui joue le rôle de sous-couche d'accrochage pour la première couche 22.

Typiquement, cette première couche 22 peut comprendre de la zircone stabilisée à l'Yttrine (YSZ), ayant une structure en bâtonnets ou colonnaire. La première couche 22 peut présenter une rugosité non nulle sur sa surface externe (c'est-à-dire sa surface opposée au substrat 1). La première couche 22 assure l'isolation thermique du revêtement 2 formant une barrière thermique et protège le substrat 1 de la chaleur des gaz de la veine d'écoulement des gaz dans la turbomachine. C'est également cette première couche 22 qui peut être dégradée par l'action des CMAS à haute température. Le revêtement 2 de la pièce revêtue selon l'invention permet de limiter cette dégradation.

En variante, la première couche 22 peut comprendre de la zircone dopée avec des terres rares, ou avec une composition à base d'oxydes ternaires. Dans la famille de systèmes ternaires, on peut par exemple citer les systèmes à base de zircone yttriée dopés par un troisième oxyde distinct tel qu'un oxyde de l'un des éléments chimiques suivants : ytterbium (Yb), néodyme (Nd), dysprosium (Dy), gadolinium (Gd), niobium (Nb), tantale (Ta), samarium (Sm).

Conformément à l'invention, le revêtement 2 comprend en outre une deuxième couche 23 comprenant majoritairement en masse un minerai de feldspath ayant une température de fusion supérieure ou égale à 1010°C. Cette couche présente une épaisseur e2 supérieure ou égale à 10 µm, par exemple supérieure à 20 µm, ou encore supérieure ou égale à 50 µm. L'épaisseur e2 de la deuxième couche 23 peut être supérieure ou égale au tiers de l'épaisseur e1 de la première couche 22.

La deuxième couche 23 ou couche de protection 23 assure la protection de la première couche 22 en céramique, en formant notamment une barrière étanche aux CMAS, et compatible chimiquement avec les CMAS. En effet, les minerais de la famille des feldspaths ayant une température de fusion supérieure à 1010°C sont tout d'abord solides aux hautes températures auxquels ils sont exposés dans la turbomachine. En outre, ils comportent une structure chimique à base d'alumine et de silice en phase majoritaire, qui leur assure une bonne compatibilité chimique avec les CMAS dans l'environnement de la turbomachine. Un tel minerai peut par exemple être de l'anorthite, ou l'un de ses polymorphes.

De façon synthétique, le revêtement 2 comprend, de la couche la plus proche à la plus éloignée du substrat 1 : une couche de liaison 20 directement au contact du substrat 1, une couche d'oxyde 21 directement au contact de la couche de liaison 20, une première couche céramique 22 directement au contact de la couche d'oxyde 21, et une deuxième couche 23 de protection directement au contact de la première couche céramique 22.

La **figure 2** montre un autre mode de réalisation d'une pièce comprenant un substrat 1 recouvert d'un revêtement 2' selon l'invention. Dans cet exemple, le revêtement 2' comprend en outre une troisième couche de protection 24 recouvrant la couche d'oxyde 21 et disposée au-dessous de la première couche 22 en céramique. La troisième couche de protection 24 est ici directement au contact de la couche d'oxyde 21 et de la première couche 22 en céramique.

Cette disposition est avantageuse en ce qu'elle permet de disposer d'une autre couche étanche 24 ou troisième couche 24 étanche sous la première couche 22 en céramique, et permet d'éviter, dans le cas où les CMAS traverseraient la couche 22, qu'ils n'atteignent le substrat 1 et le dégradent. La troisième couche 24 présente une composition du même type que celle de la deuxième couche 23, et peut comprendre majoritairement en masse un deuxième minerai de feldspath ayant une température de fusion supérieure ou égale à 1010°C. Le deuxième minerai de feldspath peut être identique au premier minerai de la deuxième couche 23, ou différent de celui-là.

Une telle disposition n'est pas possible avec les couches de protection de l'art antérieur, car ces couches ne sont généralement pas compatibles avec le matériau de la couche d'oxyde 21. A titre d'exemple, une couche de protection de l'art antérieur à base de zircone dopée au gadolinium se dégrade par réaction avec l'alumine en formant un aluminiure de gadolinium. La formation de cet aluminiure de gadolinium conduit à une augmentation de volume et également à la formation de porosités, ce qui fragilise considérablement l'ensemble du revêtement. La troisième couche 24 selon l'invention est quant à elle compatible avec l'alumine de la couche d'oxyde 21 parce qu'elle comprend notamment une phase alumine.

Le revêtement 2" de la **figure 3** comprend une quatrième couche 25 recouvrant la deuxième couche 23 de protection, ayant pour but d'augmenter encore la protection de la couche 22 en céramique. Cette quatrième couche 25, au contact de la deuxième couche 23, comprend de l'alumine et/ou de l'oxyde de titane. L'alumine et l'oxyde de titane sont des composés pouvant réagir avec les CMAS liquides et favoriser leur précipitation. On notera qu'il est également envisageable d'utiliser pour la quatrième couche 25 des oxydes de terres rares, par exemple un oxyde d'yttrium, de zirconium, de gadolinium, de lanthane, de samarium, etc. Ainsi, avec une telle couche supplémentaire, on augmente encore la durée de vie du revêtement 2".

En variante, on peut ajouter de l'alumine et/ou de l'oxyde de titane dans la deuxième couche 26 de protection (comme dans le revêtement 2"' de la **figure 4**), pour augmenter l'efficacité de la protection du revêtement. Par exemple, de l'alumine et/ou de l'oxyde de titane peuvent être ajoutés sous forme de poudre lors du dépôt de la deuxième couche de protection.

### Exemple

Dans les exemples suivants, on s'intéresse à l'utilisation de l'anorthite comme minerai de feldspath de la deuxième couche 23 ou de la troisième couche de protection 24, et à l'un de ses procédés de dépôt.

L'anorthite, de formule générale CaAl₂Si₂O₈ présente des avantages supplémentaires par rapport à d'autres feldspaths, notamment un point de fusion congruent à plus de 1500°C qui lui procure encore une meilleure stabilité chimique à haute température. Aussi, elle présente un coefficient de dilatation thermique proche de celui d'un superalliage, et une conductivité thermique comparable à celle de la céramique formant la première couche 22.

De manière générale, l'anorthite stoechiométrique comprend en masse : 20,16% de monoxyde de calcium (CaO), 36,66% d'alumine (Al₂O₃) et 43,19% de silice (SiO₂). Cette composition est avantageuse pour les raisons suivantes.

Dans les régions désertiques, l'oxyde de calcium est présent dans les sables à hauteur de 15% massique et la silice en est le composé principal. Lorsque ces sables sont ingérés par la turbomachine, la deuxième couche de protection 23 est compatible chimiquement avec ces composés. Cette couche 23 comprenant majoritairement en masse de l'anorthite conserve donc une forme cristallisée et reste étanche aux CMAS.

En outre, il est connu que les composés aluminosilicates peuvent réagir avec l'eau, qui peut être présente sous forme d'humidité résiduelle lorsque la turbomachine est à l'arrêt, ou générée lors de la combustion du combustible avec l'air. Cependant, la réaction de décomposition de l'anorthite avec l'eau est très lente dans les conditions de fonctionnement de la turbomachine. De même, d'autres réactions de décomposition de l'anorthite sont connues, mais présentent des cinétiques tout aussi lentes dans les conditions de pression et de température considérées, et donc non pertinentes dans une application turbomachine.

Un procédé de dépôt d'une deuxième couche de protection 23 à base d'anorthite va maintenant être décrit sommairement.

On procède tout d'abord à la synthèse de l'anorthite. Des réactifs tels que du kaolin (source de silicium et d'aluminium), de l'alumine ou un hydroxyde d'aluminium (source d'aluminium), et de la chaux ou du carbonate de calcium (source de calcium) sont préparés. Le tableau 1 ci-après donne deux exemples (E1, E2) des quantités de chaque constituant à utiliser pour réaliser environ 90g d'anorthite (le rendement obtenu avec le mode opératoire décrit ci-après est de l'ordre de 90%). En vue d'améliorer le rendement, il est par exemple possible d'ajouter de l'acide borique H₃BO₃ à 1% massique.

**Tableau 1**

| | | E1 | E2 |
|---|---|---|---|
| Kaolin | Al₂Si₂O₅ (OH)₄ | 80g | 62g |
| Chaux | Ca(OH)₂ | 20g | |
| Carbonate de Calcium | CaCO₃ | | 28g |
| Hydroxyde d'Aluminium | Al(OH)₃ | | 10g |

Les réactifs sous forme de poudre sont mélangés au moyen d'un broyeur lubrifié avec de l'eau distillée. Le mélange est ensuite soumis à une pression de compression au moyen de billes en céramique (en zircone par exemple) dont les paramètres significatifs sont les suivants : une pression comprise entre 100MPa et 150MPa, une vitesse de rotation comprise entre 100 tours/minute et 500 tours/minute, et une durée de broyage comprise entre 20 min et 60 min. Ces valeurs sont bien entendu données à titre illustratif.

Ensuite, on procède au séchage du mélange qui a été broyé pour éliminer toute humidité résiduelle, en général à une température comprise entre 100 et 120°C.

Puis, on termine le procédé de synthèse en calcinant le mélange broyé et séché à une température comprise entre 900°C et 1080°C pendant un temps de palier compris entre 1 heure et 6 heures. Le refroidissement est ensuite réalisé sous air sec.

Enfin, on peut réaliser le dépôt de l'anorthite ainsi synthétisée par différents moyens connus de l'homme du métier, tels que : le sol-gel, la barbotine, le dépôt chimique en phase vapeur, la pulvérisation, la projection thermique (et ses dérivés : SPS ou « Suspension Plasma Spraying », SPPS ou « Solution Precursor Plasma Spray »), la projection de type HVOF (ou « High Velocity Oxy Fuel »), ou encore par dépôt physique en phase vapeur avec faisceau d'électron (EB-PVD). Pour ces dépôts, l'anorthite synthétisée est préférentiellement sous la forme d'une poudre présentant une granulométrie moyenne de quelques microns. Suite au dépôt de l'anorthite, il est possible d'effectuer un traitement thermique pour achever la formation du revêtement de protection sur le substrat et contrôler la cristallinité de la deuxième couche de protection 23.

On notera que, lors du dépôt de la poudre d'anorthite pour réaliser une deuxième couche 23 (figures 1 et 2) ou une troisième couche 24 (figure 3), il est possible d'incorporer une poudre d'alumine et/ou d'oxyde de titane à la poudre d'anorthite au moment du dépôt afin de former une quatrième couche 26 (figure 4) multiphasique.

## Revendications

1. Pièce revêtue comprenant un substrat métallique et/ou intermétallique (1) et un revêtement de protection (2 ; 2' ; 2" ; 2'") formant une barrière thermique recouvrant ledit substrat, le revêtement de protection comprenant une première couche céramique (22), **caractérisé en ce qu'**il comprend en outre une deuxième couche (23 ; 26) présente sur la première couche, la deuxième couche comprenant majoritairement en masse un premier minerai de feldspath ayant une température de fusion supérieure ou égale à 1010°C et présentant une épaisseur (e2) supérieure ou égale à 10 µm, la deuxième couche présentant un taux de cristallinité supérieur ou égal à 5%.

2. Pièce selon la revendication 1, **caractérisée en ce que** la deuxième couche présente une épaisseur (e2) supérieure ou égale à 20 µm.

3. Pièce selon l'une quelconque des revendications 1 et 2, **caractérisée en ce que** la première couche céramique (22) comprend de la zircone.

4. Pièce selon la revendication 3, **caractérisée en ce que** la première couche céramique (22) comprend de la zircone stabilisée à l'Yttrine.

5. Pièce selon l'une quelconque des revendications 1 à 4, **caractérisée en ce que** la deuxième couche (23 ; 26) comprend majoritairement en masse de l'anorthite.

6. Pièce selon l'une quelconque des revendications 1 à 5, **caractérisée en ce que** le revêtement (2') comprend en outre une troisième couche (24) comprenant majoritairement en masse un deuxième minerai de feldspath ayant une température de fusion supérieure ou égale à 1010°C, la troisième couche étant située sous la première couche (22).

7. Pièce selon l'une quelconque des revendications 1 à 6, **caractérisée en ce que** le revêtement (2") comprend en outre une quatrième couche (25) recouvrant la deuxième couche (23 ; 26) comprenant de l'alumine et/ou de l'oxyde de titane.

8. Pièce selon l'une quelconque des revendications 1 à 7, **caractérisée en ce que** la deuxième couche (26) comprend en outre de l'alumine et/ou de l'oxyde de titane.

9. Procédé de fabrication d'une pièce revêtue comprenant un substrat métallique et/ou intermétallique (1) et un revêtement de protection (2 ; 2' ; 2" ; 2'") formant une barrière thermique recouvrant ledit substrat, le procédé comprenant la formation d'une première couche céramique (22) sur le substrat métallique et/ou intermétallique, **caractérisé en ce qu'**il comprend en outre la formation sur la première couche céramique d'une deuxième couche (23 ; 26), la deuxième couche comprenant majoritairement en masse un minerai de feldspath ayant une température de fusion supérieure ou égale à 1010°C et présentant une épaisseur supérieure ou égale à 10 µm, la deuxième couche présentant un taux de cristallinité supérieur ou égal à 5%.

10. Procédé d'utilisation d'une pièce revêtue selon l'une quelconque des revendications 1 à 8, comprenant l'utilisation de la pièce dans un environnement oxydant à une température supérieure à 1000°C et en présence d'aluminosilicates de calcium et de magnésium.

## Patentansprüche

1. Beschichtetes Teil, umfassend ein metallisches und/oder intermetallisches Substrat (1) und eine Schutzbeschichtung (2; 2'; 2"; 2"'), die eine das Substrat bedeckende Wärmebarriere bildet, wobei die Schutzbeschichtung eine erste Keramikschicht (22) umfasst, **dadurch gekennzeichnet, dass** sie ferner eine zweite Schicht (23; 26) umfasst, die auf der ersten Schicht vorhanden ist, wobei die zweite Schicht massenmäßig überwiegend ein erstes Feldspaterz mit einer Schmelztemperatur von über oder gleich 1010 °C umfasst und eine Dicke (e2) von mehr als oder gleich 10 µm aufweist, wobei die zweite Schicht einen Kristallinitätsgrad von mehr als oder gleich 5 % aufweist.

2. Teil nach Anspruch 1, **dadurch gekennzeichnet, dass** die zweite Schicht eine Dicke (e2) von mehr als oder gleich 20 µm aufweist.

3. Teil nach einem der Ansprüche 1 und 2, **dadurch gekennzeichnet, dass** die erste Keramikschicht (22) Zirkonoxid umfasst.

4. Teil nach Anspruch 3, **dadurch gekennzeichnet, dass** die erste Keramikschicht (22) Yttrin-stabilisiertes Zirkonoxid umfasst.

5. Teil nach einem der Ansprüche 1 bis 4, **dadurch gekennzeichnet, dass** die zweite Schicht (23; 26) massenmäßig überwiegend Anorthit umfasst.

6. Teil nach einem der Ansprüche 1 bis 5, **dadurch gekennzeichnet, dass** die Beschichtung (2') ferner eine dritte Schicht (24) umfasst, die massenmäßig überwiegend ein zweites Feldspaterz mit einer Schmelztemperatur von über oder gleich 1010 ºC aufweist, wobei sich die dritte Schicht unter der ersten Schicht (22) befindet.

7. Teil nach einem der Ansprüche 1 bis 6, **dadurch gekennzeichnet, dass** die Beschichtung (2") ferner eine die zweite Schicht (23; 26) bedeckende vierte Schicht (25) umfasst, die Aluminiumoxid und/oder Titanoxid umfasst.

8. Teil nach einem der Ansprüche 1 bis 7, **dadurch gekennzeichnet, dass** die zweite Schicht (26) ferner Aluminiumoxid und/oder Titanoxid umfasst.

9. Verfahren zur Herstellung eines beschichteten Teils, umfassend ein metallisches und/oder intermetallisches Substrat (1) und eine Schutzbeschichtung (2; 2'; 2"; 2"'), die eine das Substrat bedeckende Wärmebarriere bildet, wobei das Verfahren die Bildung einer ersten Keramikschicht (22) auf dem metallischen und/oder intermetallischen Substrat umfasst, **dadurch gekennzeichnet, dass** es ferner die Bildung einer zweiten Schicht (23; 26) auf der ersten Keramikschicht umfasst, wobei die zweite Schicht massenmäßig überwiegend ein Feldspaterz mit einer Schmelztemperatur von über oder gleich 1010 °C umfasst und eine Dicke von mehr als oder gleich 10 µm aufweist, wobei die zweite Schicht einen Kristallinitätsgrad von mehr als oder gleich 5 % aufweist.

10. Verfahren zur Verwendung eines beschichteten Teils nach einem der Ansprüche 1 bis 8, umfassend die Verwendung des Teils in einer oxidierenden Umgebung bei einer Temperatur von über 1000 °C sowie in Gegenwart von Calcium- und Magnesiumaluminosilikaten.

## Claims

1. A coated part comprising a metallic and/or intermetallic substrate (1) and a protective coating (2; 2'; 2"; 2"') forming a thermal barrier covering said substrate, the protective coating comprising a ceramic first layer (22) and the part being **characterized in that** the protective coating further comprises a second layer (23; 26) present on the first layer, the second layer comprising a majority by weight of a first feldspar mineral having a melting temperature higher than or equal to 1010°C and presenting a thickness (e2) greater than or equal to 10 µm, the second layer presenting a degree of crystallinity that is greater than or equal to 5%.

2. A part according to claim 1, **characterized in that** the second layer presents a thickness (e2) greater than or equal to 20 µm.

3. A part according to claim 1 or claim 2, **characterized in that** the ceramic first layer (22) comprises zirconia.

4. A part according to claim 3, **characterized in that** the ceramic first layer (22) comprises yttrium-stabilized zirconia.

5. A part according to any one of claims 1 to 4, **characterized in that** the second layer (23; 26) comprises a majority by weight of anorthite.

6. A part according to any one of claims 1 to 5, **characterized in that** the coating (2') further comprises a third layer (24) comprising a majority by weight of a second feldspar mineral having a melting temperature greater than or equal to 1010°C, the third layer being situated under the first layer (22).

7. A part according to any one of claims 1 to 6, **characterized in that** the coating (2") further comprises a fourth layer (25) covering the second layer (23; 26) and comprising alumina and/or titanium oxide.

8. A part according to any one of claims 1 to 7, **characterized in that** the second layer (26) further comprises alumina and/or titanium oxide.

9. A method of fabricating a coated part comprising a metallic and/or intermetallic substrate (1) and a protective coating (2; 2'; 2", 2"') forming a thermal barrier covering said substrate, the method comprising forming a ceramic first layer (22) on the metallic and/or intermetallic substrate, and being **characterized in that** it further comprises forming a second layer (23; 26) on the ceramic first layer, the second layer comprising a majority by weight of a feldspar mineral having a melting temperature higher than or equal to 1010°C and presenting a thickness greater than or equal to 10 µm, the second layer presenting a degree of crystallinity that is greater than or equal to 5%.

10. A method of using a coated part according to any one of claims 1 to 8, comprising using the part in an oxidizing environment at a temperature higher than 1000°C and in the presence of aluminosilicates of calcium and of magnesium.
